**Europäisches Patentamt**

**European Patent Office**

**Office européen des brevets**

(11) Veröffentlichungsnummer: **0 015 322**
**A1**

## EUROPÄISCHE PATENTANMELDUNG

(21) Anmeldenummer: **79200169.5**

(22) Anmeldetag: **06.04.79**

(51) Int. Cl.³: **H 01 L 35/00, H 01 L 43/06**

(30) Priorität: **28.02.79 EP 79200098**

(43) Veröffentlichungstag der Anmeldung: **17.09.80**
**Patentblatt 80/19**

(84) Benannte Vertragsstaaten: **BE CH DE FR GB IT LU NL SE**

(71) Anmelder: **Krückemeier, Horst, Blücherstrasse 36, D-4970 Bad Oeynhausen 1 (DE)**

(72) Erfinder: **Koenig, Klaus-Wilhelm, Dipl.-Ing., Schulstrasse 23 Postfach 100432, D-4970 Bad Oeynhausen 1 (DE)**

(54) **Sammler für Strahlungsenergie zur Umwandlung in Elektrizität.**

(57) Sammler für Strahlungsenergie zur Umwandlung in Elektrizität. Mit Sammlerplatte (1), durch die die Strahlungsenergie über verspiegelte, reflektierende, konkav spärische, parabolische oder elliptische Sammler-Wirkungsflächen (3) gesammelt wird.

Und in deren Mitte sich ein Thermoelement (10), mit jeweils einem zweiten Thermoelement (10) in der isolierenden Zwischenwand (9) des Sammlers, befindet. Und zwar zur Erzeugung eines Stromkreises aus Einzel-, bzw. Reihen- oder Parallelschaltung mit Dioden (17); in die noch wahlweise Induktionsspulen (11) mit Dauermagnetkernen (12) zwischengeschaltet sind.

Die Nutzanwendung wird aber auch ohne Induktionsspulen (11), nur mit Dauermagnetkernen (12) erzielt. Diese sind auf die Indiumarsenid-, Indiumantimonid-, bzw. ähnliche oder andere Halbleiter-Materialien in Plättchenform (13) gerichtet, erhalten von den Thermoelementen (10) den Steuerstrom, und dadurch liefern sie als Hallgeneratoren das zu verwertende elektrische Ausgangspotential der Hallspannung. Die Ausgangspotentiale aller Hallgeneratoren liefern über Reihenschaltung oder Parallelschaltung mit Dioden (17), sowie auch noch wahlweise über eine elektronische Schaltung mit Transistoren, die elektrische Energie des Sammlers. Diese elektronische Schaltung arbeitet als galvanischer Verstärker. Über eine solche elektronische Schaltung mit Transistoren können auch die Thermoelemente (10), vor den Hallgeneratoren entsprechend, geschaltet werden.

0015322

- 1 -

## Sammler für Strahlungsenergie zur Umwandlung in Elektrizität.

Die Erfindung bezieht sich auf einen Sammler für Strahlungsenergie der Sonne, die von diesem in die Energieform der Elektrizität umgewandelt wird.

Bei derartigen Sammlern kommt es darauf an die Strahlungsenergieform des elektromagnetischen Spektrums, welches nicht nur das Licht der Sonne liefert, in nutzbarer Elektrizität maximalster Leistung zu erhalten.

Es sind eine Menge von Kollektoren für Sonnenlicht dem Stande der Technik nach entsprechend im Patentschrifttum bekannt, welche Sonnenenergie sammeln und in Wärme oder elektrische Energie umformen; jedoch alle mit einem unbefriedigendem Wirkungsgrade und eben solchen Leistungen. In der vorliegend und umseitig beschriebenen Erfindungsangelegenheit wurden weder in den Bänden der Hütte, noch in den VDI und ähnlichen, technischen Veröffentlichungen und, soweit dem Verfasser dieser Patentschrift bekannt geworden - noch in Patentschriften -, Hinweise gefunden.

Weil kein Hinweismaterial im Schrifttum gefunden wurde, konnte auch keine Kritik des Standes der Technik vorgenommen werden, da es sich bei dieser Patentanmeldung um eine Neuheit handelt.

Die Erfindung, wie Sie in den Ansprüchen gekennzeichnet ist, schafft Abhilfe durch die gestellte Aufgabe, die die Vielzahl der am Markt befindlichen Sonnenkollektoren geringer Nutzeffekte vermindert und durch einen solchen von optimaler Leistung ersetzt, um somit die Lagerhaltung und Rationalisierung zu verbessern.

Die Aufgabe wird fernerhin dadurch gelöst, daß die erreichten Vorteile durch die Erfindung im wesentlichen darin zu sehen sind, maximale Wirkungsgrade durch Bündelung kleinster, konkav sphärischer, parabolischer oder elliptischer Flächen zu erzielen. Sodann findet der thermoelektrische Effekt nach Seebeck, aus der thermoelektrischen Spannungsreihe, sowie der Hall-Effekt, Anwendung. Außerdem bewirkt die Neuerung in der Serie der bekannten Sammler für Strahlungsenergie der Sonne einen wesentlichen, technischen Fortschritt gegenüber den bekannten Aggregaten.

Im nachfolgenden wird die Erfindung anhand von lediglich einen Ausführungsweg darstellenden Zeichnungen näher erläutert. Es zeigt

Figur 1 einen erfindungsgemäßen Sammler und

Figur 2 einen Schnitt A - B in Seitenansicht im gleichen Maßstabe; ferner zeigt

Figur 3 den Teil eines Stromlaufplanes einer Thermosäule des Sammlers in Reihenschaltung. Und die Hallgeneratoren in Parallelschaltung mit Dioden.

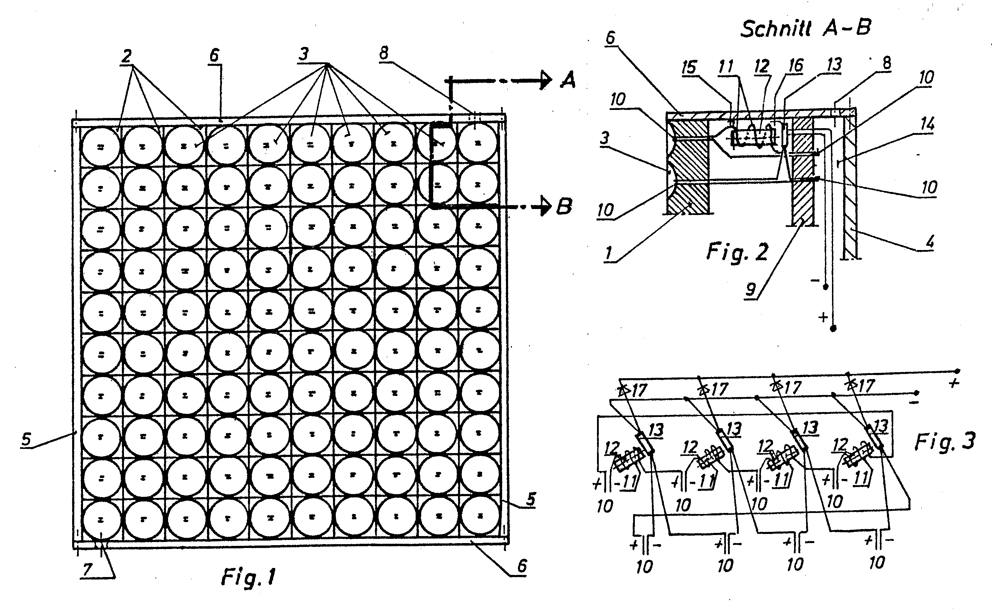

In der Figur 1 und Figur 2 ist ein Sammler für Strahlungsenergie der Sonne, die von diesem in die Energieform der Elektrizität umgewandelt wird, dargestellt. Der ferner in seinem grundsätzlichen Aufbau aus einer Sammlerplatte 1, die verspiegelt, verchromt oder aber, mit einer anderen reflektierenden Schicht überzogen ist, besteht. Diese Sammlerplatte 1 ist sodann in eine Vielzahl von kleinstmöglichen, quadratischen Sektoren 2 unterteilt. Und zwar zum Zwecke der Bündelung kleinster, konkav sphärischer, parabolischer oder elliptischer Sammler-Wirkungsflächen 3, die sich als Vertiefungen in Sammlerplatte 1 darstellen. Die Sammlerplatte 1 ist durch eine isolierende Rückwand-Abdeckplatte 4, Seitenteilen 5 und 6, als Kastenform begrenzt. Seitenteil 6 hat ferner jeweils noch die Einlaßöffnung 7, sowie die Auslaßöffnung 8, für Kühlmedium. Der Sammler wird außerdem durch die isolierende Zwischenwand 9 unterteilt, um den Kühlraum 14 zu erhalten. Jeweils zentral liegt in jeder konkav sphärischen, parabolischen oder elliptischen Sammler-Wirkungsfläche 3 ein Thermoelement 10. Das nach der thermoelektrischen Spannungsreihe ausgewählt ist, da Thermoelemente 10 nach dem Ohmschen Gesetz große Ströme von 100 Ampère und mehr erzeugen, wenn man den Widerstand des Stromkreises klein hält. In die von den Thermoelementen 10 erzeugten Stromkreise von 100 Ampère und mehr sind jeweils abwechselnd Induktionsspulen 11, mit Dauermagnetkernen 12 maximalster Feldstärken nach Gauß, die mit den Bügeln 15 entsprechend ihren Lagen im Sammler befestigt werden; sowie zur Erzeugung des Hall-Effektes, Indiumarsenid-, Indiumantimonid-, bzw. ähnliche oder andere Halbleiter-Materialien in Plättchenform 13 - minimalster Hall-Konstante -, eingebaut. Der Sammler kann auch ohne Induktionsspulen 11 betrieben werden. Dann wird der Strom der Thermoelemente 10 direkt als Steuerstrom auf die Indiumarsenid-, Indiumantimonid-, bzw. ähnliche oder andere Halbleiter-Materialien in Plättchenform 13 geschaltet und zwar in Reihenschaltung oder Parallelschaltung mit Dioden 17; auf diese sind dann die Dauermagnete 12 gerichtet, die die Feldstärken nach Gauß liefern. Das Potential der Hallspannung wird von den Indiumarsenid-, Indiumantimonid-, bzw. ähnlichen oder anderen Halbleiter-Materialien in Plättchenform 13 abgenommen, diese sind über Halterungen 16 an der Zwischenwand 9 des Sammlers befestigt.

Die einzelnen Thermoelemente 10 des Sammlers, sowie die Hallgeneratoren des Sammlers, bestehend aus den Induktionsspulen 11, Dauermagnetkernen 12 und den Indiumarsenid-, Indiumantimonid-, bzw. ähnlichen oder andren Halbleiter-

– 4 –

Materialien in Plättchenform 13, – oder aber, als Hallgeneratoren ohne Induktionsspulen 11, aber mit Dauermagnetkernen 12 und den Indiumarsenid-, Indiumantimonid-, bzw. ähnlichen oder anderen Halbleiter-Materialien in Plättchenform 13 –; können dann, jeweils für sich, einzeln, untereinander in einer Reihe, parallel mit Dioden 17, bzw. in Kombinationsformen aus Reihenschaltung und Parallelschaltung mit Dioden 17, sowie ferner, wahlweise durch eine elektronische Schaltung mit Transistoren, geschaltet werden.

Das zu verwertende elektrische Ausgangspotential liefert die Hallspannung aller Hallgeneratoren des Sammlers.

Patentansprüche:

1. Sammler für Strahlungsenergie zur Umwandlung in Elektrizität, bestehend aus der Sammlerplatte (1), die in kleinstmögliche, quadratische Sektoren (2) unterteilt ist, um in diesen kleinstmöglichen quadratischen Sektoren (2), konkav sphärische, parabolische oder elliptische Sammler-Wirkungsflächen (3), als Vertiefungen anzubringen, die verspiegelt, verchromt oder aber, mit einer anderen reflektierenden Schicht überzogen sind,
dadurch gekennzeichnet,
daß im Mittelpunkt dieser Bündelung einer Vielzahl von Sammler-Wirkungsflächen (3), sich jeweils ein Thermoelement (10), das nach der thermoelektrischen Spannungsreihe ausgewählt wurde, befindet. Und dazu, entsprechend je nach Schaltung, sich zur Erzeugung des Thermostromes noch ein dazugehöriges Thermoelement (10) in der isolierten Zwischenwand (9), in Richtung Kühlraum (14), befindet. Und diese Thermoelemente (10) außerdem wahlweise, auch in einer Reihe oder parallel mit Dioden (17), zu Schaltungen verbunden werden können.

2. Sammler für Strahlungsenergie zur Umwandlung in Elektrizität nach Patentanspruch 1, bei dem die Vielzahl der Thermoelemente (10) in Einzel-, Reihen- oder Parallelschaltung mit Dioden (17), aber auch wahlweise über eine elektronische Schaltung mit Transistoren, geschaltet werden,
dadurch gekennzeichnet,
daß die hohen Ströme aus der Bündelung der Vielzahl der Thermoelemente (10), die 100 Ampère und mehr betragen können, vermittels zwischengeschalteten Induktionsspulen (11), mit Dauermagnetkernen (12) maximalste Feldstärken nach Gauß erzeugen. Die auf die Indiumarsenid-, Indiumantimonid-, bzw. ähnliche oder andere Halbleiter-Materialien in Plättchenform (13) gerichtet sind, welche ebenfalls aus den Thermoelementen (10), die einzeln, in einer Reihe oder parallel mit Dioden (17), geschaltet werden, hohe Ströme von 100 Ampère und mehr , als Steuerströme erhalten, und somit an den Indiumarsenid-, Indiumantimonid-, bzw. ähnliche oder andere Halbleiter-Materialien in Plättchenform (13), das Potential der Hallspannung abgenommen werden kann. Und die einzelnen Potentiale der Hallspannung in Reihen-, bzw. Parallelschaltung mit Dioden (17) und auch noch wahlweise, durch eine elektronische Schaltung mit Transistoren, geschaltet werden.

3. Sammler für Strahlungsenergie zur Umwandlung in Elektrizität nach Patentanspruch 1, bei dem die Vielzahl der Thermoelemente (10), in Einzel-, Reihen- oder Parallelschaltung mit Dioden (17), auch wahlweise noch über eine elektronische Schaltung mit Transistoren, geschaltet werden können,
dadurch gekenntzeichnet,
daß die hohen Ströme der Vielzahl der Thermoelemente (10), die 100 Ampère und mehr betragen können, die Indiumarsenid-, Indiumantimonid-, bzw. ähnliche oder andere Halbleiter-Materialien in Plättchenform (13), mit Steuerströmen versorgen und Dauermagnetkerne (12) die Feldstärken nach Gauß erzeugen, die auf die Indiumarsenid-, Indiumantimonid-, bzw. ähnliche oder andere Halbleiter-Materialien in Plättchenform (13) gerichtet sind. Dabei kann das Potntial der Hallspannung an den Indiumarsenid-, Indiumantimonid-, bzw. ähnlichen oder anderen Halbleiter-Materialien in Plättchenform (13) abgenommen, und in Reihen- oder Parallelschaltung mit Dioden (17), und auch noch wahlweise, durch eine elektronische Schaltung mit Transistoren, geschaltet werden.

4. Sammler für Strahlungsenergie zur Umwandlung in Elektrizität nach Patentanspruch 1, bestehend aus der Sammlerplatte (1), die in kleinstmögliche, quadratische Sektoren (2) unterteilt ist,

dadurch gekenntzeichnet,

daß die Bündelung einer Vielzahl der konkav sphärischen, parabolischen oder elliptischen Sammler-Wirkungsflächen (3) auf der Sammlerplatte (1), verfahrensmäßig hergestellt werden kann, indem die entsprechend angepaßten Werkzeuge und Maschinen zur mechanischen, chemischen, photo-chemischen oder sonstiger physikalischer Erosions- und Bearbeitungs-Verfahren, - und die somit entsprechenden technischen Vorrichtungen und technischen Mittel -, eingesetzt werden.

Fig.1

Schnitt A−B

Fig. 2

Fig. 3

− 1/1 −

0015322

| | Europäisches Patentamt | **EUROPÄISCHER RECHERCHENBERICHT** | 0015322 <br> Nummer der Anmeldung <br> EP 79 20 0169 |

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | CH - A - 108 354 (M. KOLLER) <br> * Anspruch; Unteranspruch 1 * <br><br> -- <br><br> US - A - 3 376 165 (C.G. ABBOT) <br> * Figur 3; Ansprüche 1,2,10 * <br><br> -- <br><br> GB - A - 881 596 (ALBISWERK) <br> * Ansprüche 1,2; Figuren 1,2 * <br><br> -- <br><br> FR - A - 1 296 568 (R AND R) <br> * Figur 1; Zusammenfassung, <br> Punkte 2b,c,d * <br><br> ---- | 1 <br><br><br> 1 <br><br><br> 1 <br><br><br> 1-3 |

**KLASSIFIKATION DER ANMELDUNG (Int.Cl. 3)**

H 01 L 35/00
43/06

**RECHERCHIERTE SACHGEBIETE (Int. Cl. 3)**

H 01 L 35/00
43/06

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort <br> Den Haag | Abschlußdatum der Recherche <br> 29-11-1979 | Prüfer <br> DE RAEVE |

EPA form 1503.1   06.78